Europäisches Patentamt

European Patent Office

Office européen des brevets

(19)

(11) EP 0 485 237 B1

(12) EUROPEAN PATENT SPECIFICATION

(45) Date of publication and mention
of the grant of the patent:
**13.03.1996 Bulletin 1996/11**

(51) Int Cl.6: **H01L 33/00**, H01S 3/19

(21) Application number: **91310372.7**

(22) Date of filing: **11.11.1991**

(54) **A quantum barrier semiconductor optical device**

Optische Halbleitervorrichtung mit Quanten-Sperrschicht

Dispositif optique à semi-conducteur à couche de barrière quantique

(84) Designated Contracting States:
**DE FR GB IT NL**

(30) Priority: **09.11.1990 JP 305785/90**

(43) Date of publication of application:
**13.05.1992 Bulletin 1992/20**

(73) Proprietor: **THE FURUKAWA ELECTRIC CO., LTD.**
**Tokyo 100 (JP)**

(72) Inventors:
- **Irikawa, Michinori, Furukawa Elec. Co. Ltd.
  Chiyoda-ku, Tokyo 100 (JP)**
- **Iwase, Masayuki, Furukawa Elec. Co. Ltd.
  Chiyoda-ku, Tokyo 100 (JP)**

(74) Representative: **Gibson, Stewart Harry
URQUHART-DYKES & LORD,
Three Trinity Court,
21-27 Newport Road
Cardiff CF2 1AA (GB)**

(56) References cited:
**EP-A- 0 202 089          US-A- 4 788 688**

- **PATENT ABSTRACTS OF JAPAN vol. 10, no. 129 (E-403)14 May 1986**
- **PATENT ABSTRACTS OF JAPAN vol. 12, no. 63 (E-585)25 February 1988**
- **PATENT ABSTRACTS OF JAPAN vol. 12, no. 244 (E-631)9 July 1988**
- **PATENT ABSTRACTS OF JAPAN vol. 13, no. 323 (E-791)21 July 1989**
- **PATENT ABSTRACTS OF JAPAN vol. 11, no. 4 (E-468)7 January 1987**
- **Electronics and Communications in Japan, Part. 2, vol. 71, no. 5, 1988, pages 53-60**
- **Japanese Journal of Applied Physics, Part 2, vol. 31, no. 9B, 1992, pages L1351-L1354**
- **IEEE Laser Conference, Switzerland pages 21-22, PD-10, 1990**
- **Electronics Letters, vol. 25, no. 25, December 1989, pages 1735-1737**

## Description

This invention relates to a low operating current long-wavelength region quantum barrier semiconductor optical device superior in temperature characteristic.

Prior Art :

Well known semiconductor laser diodes (LD) for long-wavelength region optical communications are double heterostructure LDs with a GaInAs or GAluAsP active layer and an InP clad layer, which are put in practical use as light sources for trunk optical communication lines.

Long-wavelength region laser devices are fitted with a Peltier device when applied to trunk line systems since they are inferior to short-wavelength region ones in temperature stability.

Lasing threshold current $I_{TH}$ of laser diodes is expressed as a function of temperature T by equation:

$$I_{TH} = I_{THO} \times exp\ (T/T_O) \qquad (1)$$

wherein T, $T_o$ represent operating temperature and characteristic temperature in degrees Kelvin respectively.

As is seen in eq(1), high $T_o$ values mean superior stability of threshold current in a wide temperature range.

For example, short-wavelength region laser diodes exhibit characteristic temperature $T_o > 150K$. In the case of long-wavelength region laser diodes, on the other hand, their characteristic temperature $T_o$ reaches 130 - 140° K for temperatures less than approximately 10 °C but Palls to 60 - 80° K above temperatures of approximately 10 °C.

The following three mechanisms have been considered as causes of low characteristic temperature of long-wavelength region laser diodes.

1 - 1    Thermal excitation and diffusion leakage of electrons from the active layer to the clad layer.

1 - 2    Leakage of hot electrons excited in the conduction band by Auger CHCC process and overflow to the clad layer.

1 - 3    Increase of light absorption due to the excitation of holes in the valence band by Auger CHHS process.

Of the above, 1-2 is said to be the main cause of lowering the characteristic temperature in long-wavelength region laser diodes.

The reasons for regarding 1-2 as the main cause of lowering the characteristic temperature $T_O$ (K) are as described in literature-1 titled:

G.P. Agrawal et al.: Long-wavelength Semiconductor

Lasers, Van Nostrand Reinhold Company, pp. 70 - 138 that the leakage current increment via (1-1) is as small as less than 100 A/cm² in the 1.3 μm region and

that the light absorption increases via (1-3) do not sufficiently explain the actual dependence of current on temperature.

How to decrease the electron overflow caused due to the Auger effect is therefore of key importance in improving the temperature characteristic of long-wavelength region laser diodes.

From this point of view, use of DCC (double carrier confinement) and MQB (multi-quantum barrier) methods have been studied to improve the temperature characteristic of long-wavelength region laser diodes.

Mentioned in literature-2:

M. Yano et al.: IEEE J. Quantum Electron. Vol. QE-19, pp. 1319-1327

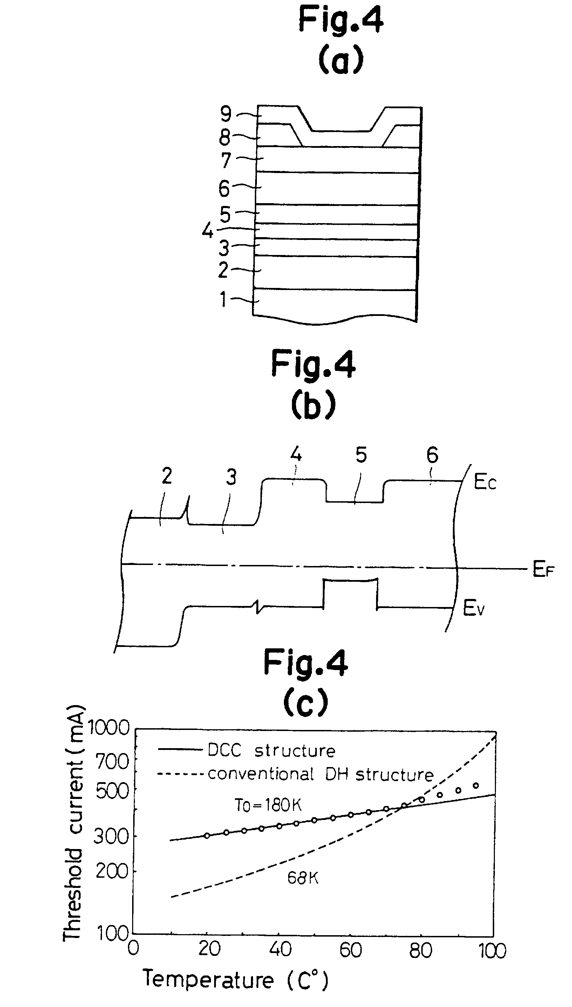

are DCC type laser diodes with cross-sectional structure, energy band diagram and temperature characteristics of threshold current as shown in Figs 4(a) to (c).

The DCC structure in Fig. 4(a) is fabricated by growing and forming an n-Inp clad layer 2, a first GaInAsP active layer 3, a p-InP middle clad layer 4, a second p-GaInAsP active layer 5, a p-InP clad layer 6, a p-GaInAsP contact layer 7, an n-InP block layer 8 and a p-electrode 9 in the order of mention on an n-InP substrate 1.

The laser diodes with such a DCC structure as shown in Fig. 4(a) show improved characteristics temperature of 130 to 210° K up to about 80°C as is shown in Fig. 4(c) and also exhibit reduced temperature dependences of the differential quantum efficiency.

The reason for such an improved temperature characteristics of the DCC structure LD is that the hot electrons overflowing from the first active layer, generating the main part of the gain required for lasing, are scattered by the middle clad layer to lose energy and are captured by the second active layer to contribute again to stimulated emission. Therefore, the DCC structure in Fig. 4(a) produces the effect equivalent to the reduction of effect 1-2.

In MQB type devices, superlattice structures are formed so as to reflect electrons as waves in such phase that the reflected and incident waves enhance each other i.e. to realize the maximum value of the reflection coefficient of incident electron waves.

Such MQB type devices are dealt with in literature-3:

Japanese Laid-Open Patent Official Gazette No.46788/1988 (JP-A-63 046 788) (Iga, Koyama and Uenohara, Tokyo Institute of Technology) and literature-4:

Iga, Uenohara and Koyama, Electronics Letters Vol.22 pp. 1008-1009, 1986

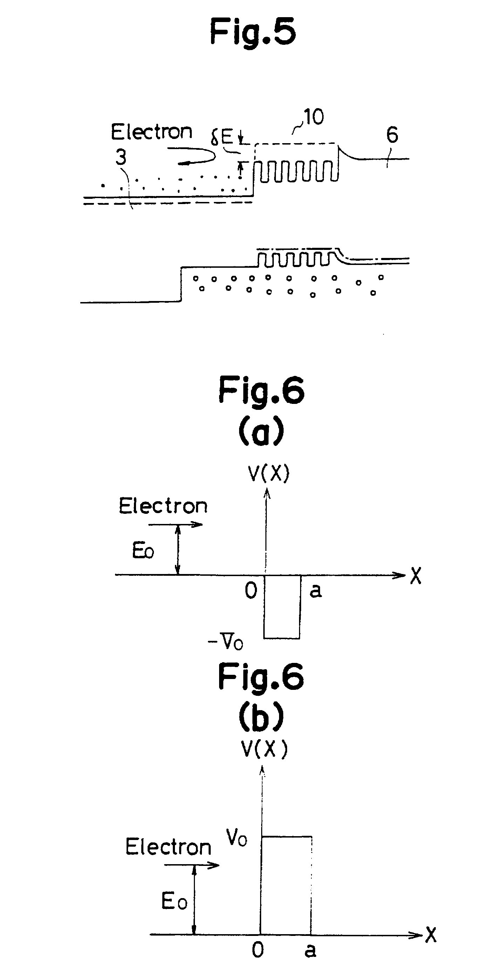

The laser diode mentioned in Literature-3 has an MQB electron reflecting layer 10 between a GaInASP active layer 3 and a p-InP clad layer 6 as schematically shown in Fig. 5.

Namely, the effective barrier height of the laser diode in Fig. 5 is made higher than the classical one by providing a plurality of periodic structures with different barrier thicknesses and well thicknesses between its GaInAsP active layer 3 and its p-InP clad layer 6.

Recently, MQB type visible red laser diodes are described in literature-5:

K. Kishino et al., IEEE, Laser Conference, Switzerland, pages 21-22, PD-10, 1990

The literature states that the characteristic temperature is increased and the threshold current density is reduced when an GaInP/AlInP MQB structure is introduced.

Problems to be Solved by the Invention:

Literature-6 : T. C. Hasenberg et al.

Applied Physics Letter, Vol. 49 No. 7, p. 400, 1986 states the following problems to be solved for DCC (double carrier confinement) structures.

2 - 1    Their threshold current densities are about twice as large as those of conventional semiconductor laser diodes.

2 - 2    When the thicknesses of the active and middle clad layers are decreased, not only the threshold current density is decreased but also the characteristic temperature falls to come close to the values of conventional semiconductor laser diodes.

The problem in 2-2 is attributed to the mechanism that the energy relaxation effect at the middle clad layer decreases, making it difficult for electrons to be captured by the second active layer.

Conventional MQB devices proposed so far pose such problems as described below.

Theoretical study is reported, as to the increase of effective barrier height in MQB structure in materials for long-wavelength region optical devices, in literature-7:

Uenohara, et al., The transactions of the Institute of electronics, information and communication engineers    Vol. J70-C No.6 pp. 851-857, 1987
It states that the effective barrier height of $Ga_{0.47} In_{0.53}$ As/InP MQB laser devices can be increased by 0.16 eV in height. Therefore, the resulting effective total barrier height is estimated to be 0.5 eV by adding the conventional hetero barrier height of 0.35 eV.

But the main cause of low characteristic temperature in long-wavelength region laser diodes is considered to be the overflow of the hot electrons generated due to the Auger CHCC process. And the maximum energy level of those hot electrons is about leV higher than the conduction band edge, therefore 0.5 eV higher than the above-mentioned effective barrier height 0.5 eV, for 1.3 $\mu$m LDs. However, there has been published no report on any MQB laser devices effective for such hot electrons, so far.

In view of what is described heretofore, the principle of MQB structures will be briefly studied with the simplified model of a one-dimensional collision problem of an electron wave with one well potential or one barrier potential known with literature-8:

L. I. Schiff, Quantum Mechanics p. 100

Continuous Eigenvalues: Collision theory, Mc-Graw-Hill. « Collision of an electron wave with one dimensional well potential »

In Fig. 6(a), symbol $V_O$ denotes the well depth, $E_0$ the energy of an incident carrier, (m) the effective mass of the carrier in the well and (a), thickness of the well.

In this case, the reflection coefficient R is given by the following equation.

$$R = 1/\{ 1 + [4E_o (E_o + V_o )]/[V_o^2 \sin^2 (k_2 a)]\} \quad (2)$$

where $k_2$ is given by :

$$k_2 = \{ [2m (E_o + V_o )/[h/2_\pi )^2\}^{1/2} \quad (3)$$

The phase condition for giving the maximum value $R_{max}$ of the reflection coefficient is given by the following equation.

$$k_2 a = [n + (1/2)]_\pi \quad (4)$$

where, n = 0, 1, 2. . .
At this condition, $R_{max}$ is given by the equation:

$$R_{max} = 1/\{ 1 + [4E_o (E_o + V_o)]/(V_o^2)\} \quad (5)$$

« Collision of an electron wave with one dimensional barrier potential »

In Fig. 6(b), symbol $V_0$ denotes barrier height, $E_0$ the energy of an incident carrier, (m) the effective mass of the carrier in the barrier and (a), thickness of the barrier.

When $E_o \geqq V_o$, the reflection coefficient R mentioned above is expressed by the equation:

$$R = 1/\{1 + [4E_0 (E_0 - V_o )]/[V_o^2 \sin^2 (k_2 a)]\} \quad (6)$$

where,

$$k_2 = \{[2m (E_o - V_o)]/[(h/2_\pi)^2\}^{1/2} \quad (7)$$

The phase condition for giving the maximum value $R_{max}$ of the reflection coefficient is given by the equation:

$$k_2 a = [n + (1/2)]_\pi \quad (8)$$

where, n = 0, 1, 2 . . . At this condition, $R_{max}$ is given by the equation:

$$R_{max} = 1/\{1 + [4E_o (E_o - V_o)]/(V_o^2)\} \quad (9)$$

When $V_o > E_o > 0$, the reflection coefficient R mentioned above is expressed by the equation:

$$R = 1/\{ 1 + [4E_o (V_o - E_o)]/[V_o^2 \sinh^2 (k_1 a)]\} \quad (10)$$

and $(k_1)$ therein is given by the equation:

$$k_1 = \{ [2m (V_o - E_o)]/[h/2_\pi)^2\}^{1/2} \quad (11)$$

In this case, therefore, there is no resonance condition so reflection coefficient R comes close to "1" with the increase of value $(k_1 a)$ when width (a) of the barrier is increased.

The MQB laser diodes which require coherency of electron wave are subject to the limitation of increasing the thickness of the barrier, because the coherent length is limited by the order of the mean free path of the carrier.

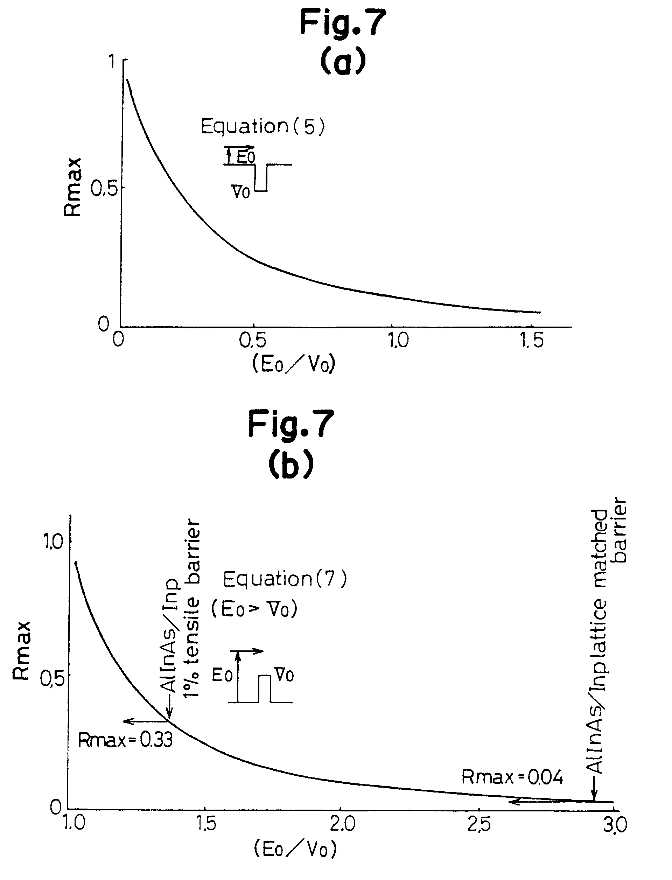

The energy level of hot electrons with maximum energy corresponds to equations (5) or (9) in the case of the well or barrier potential respectively. Therefore, $R_{max}$ values were calculated as functions of normalized incident energy ($E_o/V_o$) for equations (5) and (9), obtaining results as shown in Figs. 7(a), (b).

As is apparent from Figs. 7(a), (b), the maximum value $R_{max}$ of the reflection coefficient R decreases when the value ($E_o/V_o$) increases.

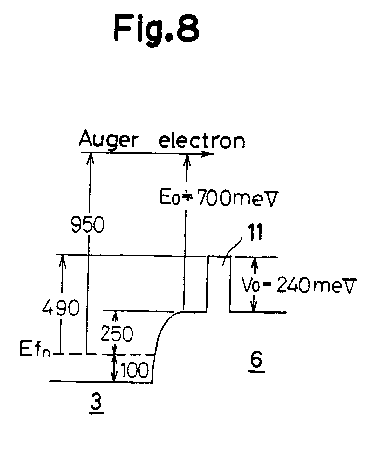

Fig. 8 shows the potential configuration of a barrier made of InP and $Al_xIn_{1-x}As$ (x = 0.48) said to have the smallest electron affinity among materials lattice-matched to InP. In the case of such barrier potential as shown in Fig. 8, an AlInAs layer 11 lattice-matched to InP is provided between p-InP clad layer 6 and GaInAsP active layer 3.

When we apply this barrier potential to 1,3 μm LD, hot electrons with maximum 950 meV gives $E_o/V_o$ = 2.93. The corresponding $R_{max}$ is 0.04 as is clear in Fig. 7(b).

Namely this barrier potential reflects only 4% of hot electrons with maximum energy even under the phase condition of maximum reflection.

In case a multi-layer barrier structure is used to obtain a reflection factor R = 1, more than 10 barrier layers are necessary for a specific incident energy. An MQB layer more than several times as thick as the above multi-layer barrier is necessary for its application to a wide range of incident energies.

This is not desirable for the afore-mentioned coherent length, i.e. it lowers coherency and decreases effect of the MQB.

As is stated heretofore, the potential materials lattice-matched to InP are not suitable for MQB layers, having no adequate function of reflecting the hot electrons generated due to Auger CHCC process.

In order to solve such problems as described heretofore the present invention is intended to provide a quantum barrier semiconductor optical device with an adequate function of reflecting the hot electrons generated due to the Auger process and with superior temperature characteristic and current characteristic (low threshold value).

In accordance with the present invention, there is provided a quantum barrier semiconductor optical device of a double heterostructure, comprising an active layer sandwiched between a lower n-clad layer and an upper p-clad layer, said active layer having at least one GaInAs or GaInAsP layer, characterised in that a strained layer superlattice multiple quantum barrier structure is disposed between said active layer and said upper p-clad layer or within said upper p-clad layer, to effect resonant scattering of incident overflowing electrons by realising a phase condition that the overflowing electron wave and reflected electron wave enhance each other.

Preferably the active layer comprises a quantum well structure.

The quantum barrier semiconductor optical device of the present invention utilizes the increase of conduction band edge discontinuity, i.e. the increase of barrier height introduced by the strained layer superlattice multiple quantum barrier structure, particularly by the superlattice barrier having an in-plane tensile strain and more particularly if the wells in this structure are given an in-plane compressive strain.

The control of band discontinuity by use of a strained layer superlattice has already been proposed in literature-9:

F. Schuemeyer et al.: Applied Physics Letter 55, pp. 1877-1878, 1989.
It states that conduction band edge discontinuity increases by 0.27 eV when $Al_xIn_{1-x}As$ is given a tensile strain of about 1% in $Al_xIn_{1-x}As/InP$ structure.

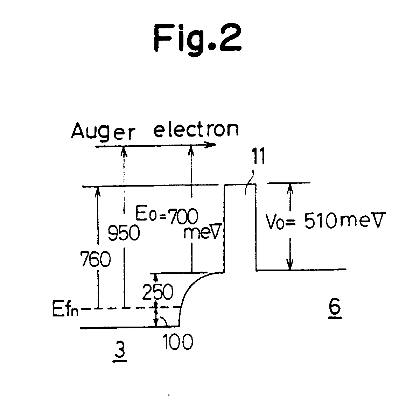

In the case a 1% tensile strained barrier is made of $Al_xIn_{1-x}As$ (x = 0.62) and InP accordingly, the barrier against the InP clad layer is given a height of 510 meV as shown in Fig. 2, described later in connection with an embodiment of the invention.

Consequently, for hot electrons with a maximum energy of 950 meV that are generated in a 1.3 μm laser diode, we can obtain the values Eo/Vo = 1.37 and $R_{max}$ = 0.33 as shown in Fig. 7(b). Above $R_{max}$ value is eight times as large as that on an un-strained quantum barrier and enough for practical use.

An MQB structure with effective reflecting function against hot electrons generated due to the Auger effect can be obtained by combining a plurality of such strained superlattice barriers so that this MQB structure can prevent hot electrons from overflowing to the clad layer.

Also, in accordance with this invention, there is provided a quantum barrier semiconductor optical device of a double heterostructure, comprising an active layer disposed between a lower n-clad layer and an upper p-clad layer, said active layer having at least one GaInAs or GaInAsP layer, characterised in that the device is of DCC type double heterostructure comprising a second active layer disposed between the first-mentioned active layer and the p-clad layer, said second active layer comprising at least one GaInAs(P) layer, a middle clad layer is disposed between the two active layers, and a strained layer superlattice multiple quantum barrier structure is disposed between the first-mentioned active layer and the middle clad layer or within said middle clad layer, and/or between said second active layer and said upper clad layer or within said upper clad layer, the or each said strained layer superlattice multiple quantum barrier structure effecting resonant scattering of incident overflowing electrons by realising a phase condition that the overflowing electron wave and reflected electron wave enhance each other.

The device is thus of DCC structure: even if the middle clad layer is decreased in thickness, the feature of the DCC structure is not lost by the MQB structure. Therefore, superior temperature characteristic and low threshold current density are realized, and the device can be expected to produce a more effective electron confinement effect.

BRIEF DESCRIPTION OF DRAWINGS

Fig. 1(a) is a cross-sectional view of a long wavelength region laser diode according to the present invention;
Fig. 1(b) shows its energy band diagram at a zero-bias condition;
Fig. 2 shows the energy band diagram of a strained superlattice barrier between the active layer and p-clad layer in a 1.3 $\mu$m LD, and the energy level of Auger electrons with maximum incident energy, the barrier consisting of an AlInAs layer with 1% of in-plane tensile strain and an InP layer;
Fig. 3(a) is a cross-sectional view of a DCC laser diode according to an embodiment of the present invention;
Fig. 3(b) shows its energy band diagram at a zero-bias condition;
Fig. 4(a) is a cross-sectional view of a conventional DCC laser diode;
Fig. 4(b) shows its energy band diagram;
Fig. 4(c) shows its temperature characteristic;
Fig. 5 shows the increase of effective hetero-barriers in an MQB structure;
Fig. 6(a) shows a one-dimensional square well potential;
Fig. 6(b) shows a one-dimensional square barrier potential;
Fig. 7(a) shows the calculated results for the dependence of maximum reflection coefficient on the ratio (Eo/Vo) of the incident energy and the depth of the well for the square well potential in Fig. 6(a);
Fig. 7(b) shows the calculated results for the dependence of maximum reflection coefficient on the ratio (Eo/Vo) of the incident energy and the height of the barrier for the square barrier potential in Fig. 6(b); and
Fig. 8 shows the energy band diagram of a lattice-matched barrier between the active layer and p-clad layer in a 1.3 $\mu$m LD and the energy level of Auger electrons with maximum incident energy, the barrier consisting of lattice-matched AlInAs and InP.

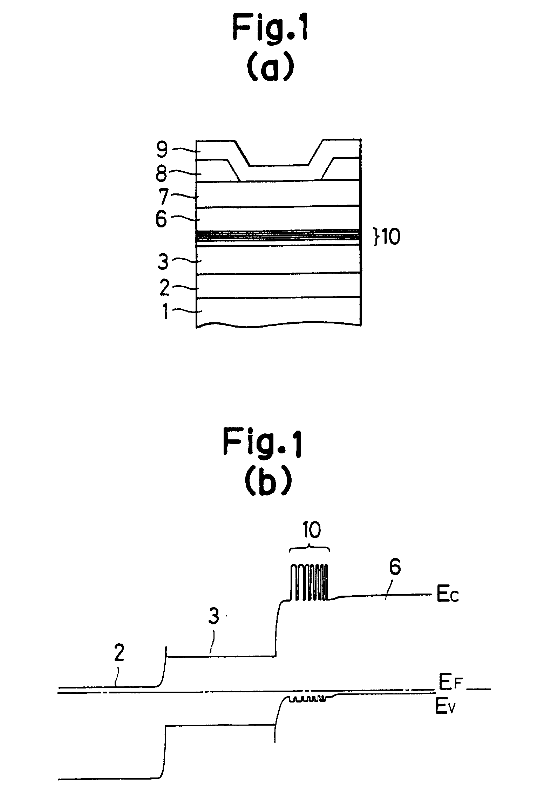

The laser diode shown in Figs. 1(a), (b) is made by depositing an n-InP clad layer 2, a GaInAsP active layer 3, a strained superlattice MQB layer 10 made of InP and 1% tensile strained $Al_xIn_{1-x}As$ (x = 0.62), a p-InP clad layer 6, a p-GaInAsP contact layer 7, an n-InP block layer 8 and a p-electrode 9 (in the order of mention) on an n-InP substrate. Strained MQB layer 10 is p-doped up to about $10^{16}$ - $10^{17}$ cm$^{-3}$.

Fig. 2 shows a potential configuration of a barrier comprising InP and $Al_xIn_{1-x}As$ (x = 0.62) involving an in-plane tensile strain of 1%. In this example, a barrier layer is provided between the p-InP clad layer 6 and GaInAsP active layer 3.

The potential configuration in Fig. 2 has a barrier height of 510 meV against the p-InP clad layer 6.

Therefore, when this strained barrier potential is applied to 1.3 $\mu$m laser diodes, a practical value of maximum coefficient $R_{max}$ can be obtained, because $E_o/V_o$ = 1.37 for the hot electrons incident with a maximum energy of 950 meV and corresponding $R_{max}$ value is 0.33 as is shown in Fig. 7(b).

That is, such strained superlattice barriers can have maximum reflection coefficient of about 30% per barrier layer. They can therefore be given a reflection coefficient of 100% by integrating a number of such strained barrier layers.

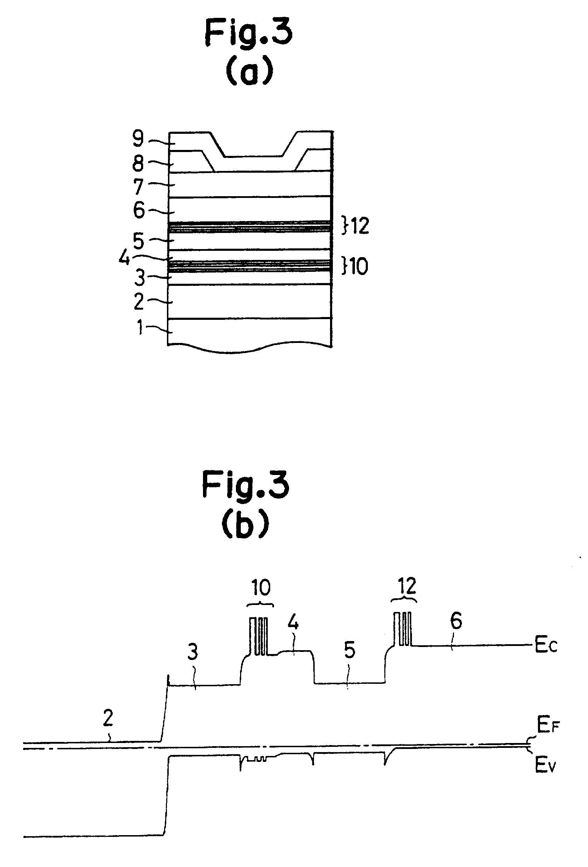

Fig. 3(a) shows the DCC laser diode as one of the other embodiments of the present invention.
Fig. 3(b) shows its energy band diagram.

The laser diode in Figs. 3(a), (b) is fabricated by depositing a 600Å -thick first GaInAsP active layer 3, a strained superlattice MQB layer 10, a 400Å -thick p-InP middle clad layer 4, a 600Å -thick second GaInAsP active layer 5, an strained superlattice MQB layer 12, a p-InP clad layer 6, a p-GaInAsP contact layer 7, an n-InP block layer 8 and a p-electrode 9 (in the order of mention) on the n-InP clad layer 2 on an n-InP substrate 1. Both active layers 3, 5 have the same band gap wavelength $\lambda$, value of 1.3 $\mu$m.

As described above, in conventional DCC structures, the characteristic temperature degrades and approaches to the value of conventional laser diode when the thickness of the middle clad layer is reduced below 100 nm (1,000Å).

In the case of the DCC laser diode in Fig. 3(a), (b), on the other hand, the hot electrons generated in the first active layer 3 are reflected by the MQB layer 10 and the electrons which travel through to the p-clad layer 6, maintaining a high energy, can be reflected by the MQB layer 12 and captured by the second active layer 5.

The DCC laser devices in Fig. 3(a), (b), therefore, permit the thickness of the middle clad layer 6 to be reduced to small values and the threshold current to be decreased, maintaining a superior temperature characteristic.

Concerning materials for the tensile strained superlattice layers, a GaInP or GaInAsP barrier layer with a tensile strain of about +5% can be also adopted as well as an AlInAs barrier with 1% tensile strain. And as to the active layer structure, a quantum well (QW) structure accompanied by a suitable SCH (Separated Confinement Heterostructure) layer can be used and realize lower threshold current density. Regarding the current blocking structure, a BH (Buried Hetero structure) or BC (Buried Crescent) structures can be used instead of the structure shown in Fig. 1 and 3.

In the above embodiments, only semiconductor laser diodes were described, but a similar effect or improvement can be expected for semiconductor laser amplifiers.

Effects of the Invention:

As is apparent from what is described heretofore, the quantum barrier semiconductor optical devices according to the invention produce such effects to be stated below.

One thereof is that we can realize an MQB layer with the effective reflecting function for the hot electrons generated due to the Auger process. As a result, overflow leakage current due to the Auger process can be well suppressed, and the temperature characteristic can be drastically improved in optical devices like LDs in long-wavelength region.

Another thereof is that a low threshold current DCC laser diode is obtainable.

## Claims

1. A quantum barrier semiconductor optical device of a double heterostructure, comprising an active layer (3) sandwiched between a lower n-clad layer (2) and an upper p-clad layer (6), said active layer (3) having at least one GaInAs or GaInAsP layer, characterised in that a strained layer superlattice multiple quantum barrier structure (10) is disposed between said active layer (3) and said upper p-clad layer (6), or within said upper p-clad layer (6),to effect resonant scattering of incident overflowing electrons by realising a phase condition that the incident overflowing electron wave and reflected electron wave enhance each other.

2. A quantum barrier semiconductor optical device of a double heterostructure, comprising an active layer (3) disposed between a lower n-clad layer (2) and an upper p-clad layer (6), said active layer (3) having at least one GaInAs or GaInAsP layer, characterised in that the device is of double carrier confinement type double heterostructure comprising a second active layer (5) disposed between the first-mentioned active layer (3) and the p-clad layer (6), said second active layer comprising at least one GaInAs or GaInAsP layer, a middle clad layer (4) is disposed between the two active layers (3,5), and a strained layer superlattice multiple quantum barrier structure (10 or 12) is disposed between the first-mentioned active layer (3) and the middle clad layer (4) or within said middle clad layer (4), and/or between said second active layer (5) and said upper p-clad layer (6) or within said upper p-clad layer (6), the or each strained layer superlattice multiple quantum barrier structure (10 or 12) effecting resonant scattering of incident overflowing electrons by realising a phase condition that the overflowing electron wave and reflected electron wave enhance each other.

3. A quantum barrier semiconductor optical device as claimed in claim 1 or 2, characterised in that the or each active layer (3,5) comprise a quantum well structure.

## Patentansprüche

1. Optische Halbleitereinrichtung mit Quantenbarriere von doppelter Heterostruktur, die eine aktive Schicht (3), die zwischen einer unteren n-Mantelschicht (2) und einer oberen p-Mantelschicht (6) angeordnet ist, wobei die aktive Schicht (3) wenigstens eine GaInAs- oder GaInAsP-Schicht aufweist, dadurch gekennzeichnet, daß eine Übergitter-Vielfachquantenbarrierenstruktur (10) mit verspannter Schicht zwischen der aktiven Schicht (3) und der oberen p-Mantelschicht (6) oder innerhalb der oberen p-Mantelschicht (6) angeordnet ist, um Resonanzstreuung von einfallenden überströmenden Elektronen durch Verwirklichung einer Phasenbeziehung zu bewirken, daß die Welle der einfallenden überströmenden Elektronen und der reflektierten Elektronen einander verstärken.

2. Optische Halbleitereinrichtung mit Quantenbarriere von doppelter Heterostruktur, die eine aktive Schicht (3), die zwischen einer unteren n-Mantelschicht (2) und einer oberen p-Mantelschicht (6) angeordnet ist, wobei die aktive Schicht (3) wenigstens eine GaInAs- oder GaInAsP-Schicht aufweist, dadurch gekennzeichnet, daß die Einrichtung vom Typ doppelter Heterostruktur mit doppelter Trägereingrenzung ist und eine zweite aktive Schicht (5) zwischen der erstgenannten aktiven Schicht (3) und der p-Mantelschicht (6) aufweist, wobei die zweite aktive Schicht wenigstens eine GaInAs- oder GaInAsP-Schicht aufweist, daß eine mittlere Mantelschicht (4) zwischen den beiden aktiven Schichten (3, 5) angeordnet ist, und daß eine Übergitter-Vielfachquantenbarrierenstruktur (10 oder 12) mit verspannter Schicht zwischen der erstgenannten aktiven Schicht (3) und der mittleren Mantelschicht (4) oder innerhalb der mittleren Mantelschicht (4) und/oder zwischen der zweiten aktiven Schicht (5) und der oberen p-Mantelschicht (6) oder innerhalb der oberen p-Mantelschicht (6) angeordnet ist, wobei die oder jede Übergitter-Vielfachquantenbarrierenstruktur (10 oder 12) mit verspannter Schicht Resonanzstreuung von einfallenden überströmenden Elektronen durch Verwirklichung einer Phasenbedingung bewirkt, daß die Welle der überströmenden Elektronen und der reflektierenden Elektronen einander verstärken.

3. Optische Halbleitereinrichtung mit Quantenbarriere nach Anspruch 1 oder 2, dadurch gekennzeichnet, daß die oder jede aktive Schicht (3, 5) eine Quantenmuldenstruktur einschließt.

**Revendications**

1. Dispositif optique à semi-conducteur à barrière quantique à double hétérostructure, comprenant une couche active (3) intercalée entre une couche de gainage de type n inférieure (2) et une couche de gainage de type p supérieure (6), ladite couche active (3) ayant au moins une couche GaInAs ou GaInAsP, caractérisé en ce qu'une structure à couche tendue à supertreillis multiple à barrière quantique (l0) est disposée entre ladite couche active (3) et ladite couche de gainage de type p supérieure (6), ou dans ladite couche de gainage de type p supérieure (6), pour effectuer une diffusion résonnante d'électrons incidents débordants réalisant une condition de phase de sorte que l'onde électronique débordante incidente et l'onde électronique réfléchie s'améliorent mutuellement.

2. Dispositif optique à semi-conducteur à barrière quantique à double hétérostructure, comprenant une couche active (3) disposée entre une couche de gainage de type n inférieure (2) et une couche de gainage de type p supérieure (6), ladite couche active (3) ayant au moins une couche GaInAs ou GaInAsP, caractérisé en ce que le dispositif à double hétérostructure est du type à confinement à double support comprenant une deuxième couche active (5) disposée entre la première couche active mentionnée (3) et la couche de gainage de type p (6), ladite deuxième couche active comprenant au moins une couche GaInAs ou GaInAsP, une couche intermédiaire de gainage (4) est disposée entre les deux couches actives (3,5), et une couche tendue à supertreillis multiple à barrière quantique (10 ou 12) est disposée entre la première couche active mentionnée (3) et la couche intermédiaire de gainage (4) ou dans ladite couche intermédiaire de gainage (4) et/ou entre ladite seconde couche active (5) et ladite couche de gainage de type p supérieure (6) ou dans ladite couche de couverture de type p supérieure (6), la ou chaque couche tendue à supertreillis multiple à barrière quantique (10 ou 12) effectuant une diffusion résonnante d'électrons incidents débordants en réalisant une condition de phase de sorte que l'onde électronique débordante ainsi que l'onde électronique réfléchie s'améliorent mutuellement.

3. Dispositif optique à semi-conducteur à barrière quantique selon la revendication 1 ou 2, caractérisé en ce que la ou chaque couche active (3,5) comprend une structure de puits quantique.

# Fig.1
## (a)

# Fig.1
## (b)

# Fig.2

# Fig.3
## (a)

# Fig.3
## (b)

# Fig.4
## (a)

# Fig.4
## (b)

# Fig.4
## (c)

# Fig.5

# Fig.6
## (a)

# Fig.6
## (b)

# Fig.7
# (a)

# Fig.7
# (b)

# Fig.8

Auger electron

$E_0 \doteq 700\,meV$

950

11

490

$V_0 = 240\,meV$

250

$Ef_n$

100

6

3